# FASCICULE DE BREVET EUROPEEN

(11) **EP 3 063 789 B1**
(45) Date de publication et mention de la délivrance du brevet: **19.07.2023**
(21) Numéro de dépôt: 14825391.7
(22) Date de dépôt: 29.10.2014
(51) Int. Cl.: H10N 97/00, H01L 23/522, H01G 4/005

(54) **STRUCTURE À CAPACITÉ AMÉLIORÉE**
STRUKTUR MIT EINEM VERBESSERTEN KONDENSATOR
STRUCTURE WITH AN IMPROVED CAPACITOR

(30) Priorité: 29.10.2013 FR 1360555
(43) Date de publication de la demande: 07.09.2016
(73) Titulaire: Murata Integrated Passive Solutions, 14000 Caen (FR); Commissariat à l'Energie Atomique et aux Energies Alternatives, 75015 Paris (FR)
(72) Inventeur: VOIRON, Frédéric, 38530 Barraux (FR); PARAT, Guy, 38640 Claix (FR)
(74) Mandataire: Cabinet Beau de Loménie
(86) Numéro de dépôt international: PCT/FR2014/052754
(87) Numéro de publication internationale: WO 2015/063420

(56) Documents cités:
- EP-A1- 1 365 444
- US-A1- 2006 014 385
- US-A1- 2011 073 827

## Description

La présente invention se rapporte de manière générale à une capacité de type Métal-Isolant-Métal. Elle concerne plus spécialement une structure à capacité de type Métal-Isolant-Métal à partir de laquelle peut être réalisé un empilement de capacités de type Métal-Isolant-Métal.

L'invention trouve des applications, en particulier, dans le domaine de la microélectronique et plus spécialement dans le domaine des composants passifs et/ou actifs utilisés par exemple dans des dispositifs médicaux, dans des dispositifs d'aide à la gestion de l'énergie, ou encore l'avionique.

Grâce à l'évolution des technologies micro-électroniques, il est maintenant possible d'intégrer plusieurs fonctions complexes sur un même composant afin d'en améliorer les performances. L'intégration de composants passifs et plus spécialement de capacités dans des circuits actifs ou passifs intégrés est un enjeu important pour les concepteurs. En effet, lors de l'intégration de tels composants, des problématiques de compatibilité technologique apparaissent entre les procédés de fabrication des capacités par exemple et des composants passifs ou actifs. De plus, des problématiques d'encombrement liées à l'utilisation de capacités avec des valeurs élevées apparaissent.

Des solutions ont été explorées, telles que par exemple, la création de capacités Métal-Isolant-Métal (MIM) s'étendant en trois dimensions.

Par exemple, le document US 2006/014385 prévoit la fabrication d'une capacité de stockage de cellule DRAM en se servant d'une couche de moulage pour créer des éléments conducteurs en forme de U, dont les branches se lèvent depuis une couche isolante disposée sur un substrat et les fonds (qui relient entre elles les branches de chaque U) entrent en contact avec des bouchons conducteurs respectifs formés dans la couche isolante. Une couche diélectrique est formée par-dessus les éléments conducteurs et une couche conductrice est formée par-dessus la couche diélectrique. Une couche de polysilicium déposée sur la structure correspond à une électrode supérieure des capacités tandis que les bouchons conducteurs constituent des électrodes inférieures.

Le document EP 1365444 également prévoit la création de capacités MIM en trois dimensions. Selon ce document on creuse un évidement dans un substrat et ensuite une structure en relief est créée en déposant des bosses dans l'évidement. Les couches d'une capacité MIM sont ensuite déposées au-dessus de la structure en relief.

Les procédé de fabrications des structures prévues par les documents US 2006/0014385 et EP 1365444 sont longues et complexes et ne permettent d'obtenir que des densités de capacités MIM médiocres.

D'autres propositions prévoient la création de capacités Métal-Isolant-Métal avec des couches anodisables permettant de faire un dépôt MIM à l'intérieur de pores obtenus dans ladite couche anodisée.

Ainsi par exemple, un procédé permettant la réalisation d'une capacité MIM à l'aide d'une couche anodisée est proposé dans la publication NATURE TECHNOLOGY de Mai 2009, « Nanotubular metal-insulator-metal capacitor arrays for energy storage » de P. Banerjee et *al..* Cette publication présente un procédé de gravure par anodisation d'une couche anodisable permettant de créer une structure à capacité MIM. Les capacités MIM ainsi créées permettent de manière relativement précise de maîtriser les valeurs des capacités. Cependant, de telles structures possèdent des résistances internes relativement élevées, ce qui détériore les performances de tels composants et limite leurs intégrations dans des circuits actifs.

En outre, malgré des rapports de surface relativement élevés, grâce à l'utilisation de couches anodisées, les densités de capacités MIM ainsi obtenues restent relativement faibles. Par conséquent, lors de la conception de capacités à fortes valeurs, il apparaît des problématiques d'encombrement liées à ce type de technologie.

Le document US2011/073827 prévoit la création de diverses structures dans une couche anodisée, dont une capacité. L'une des structures décrit dans le document US 2011/073827 comporte une capacité MIM composée de première et deuxième couches conductrices, séparées par une couche diélectrique, disposées toutes dans un pore d'une couche anodisée. Cette structure est fabriquée en faisant croître, par anodisation, une couche poreuse d'oxyde sur une couche d'aluminium, et en déposant ensuite dans les pores les couches de la capacité MIM. Afin de permettre un contact avec la structure MIM depuis le bas, on enlève ensuite par gravure tout ou une partie de l'aluminium restant (au moins dans les emplacements en dessous des pores), afin d'ouvrir les fonds des pores. Une couche conductrice est ensuite placée en dessous des pores pour constituer une électrode inférieure.

L'approche préconisée par le document US 2011/073827 comporte l'inconvénient majeur qu'il implique un besoin de manipuler une feuille d'aluminium anodisée, élément délicat et susceptible d'être rompu ou endommagé lors de l'achèvement du procédé de fabrication. Par ailleurs, le procédé de fabrication proposé n'est guère compatible avec l'intégration d'une capacité dans un circuit intégré, notamment lorsqu'il faut former la capacité au-dessus de composants actifs ou passifs déjà fabriqués.

L'invention vise à surmonter les inconvénients de l'art antérieur précités, et plus particulièrement, à permettre la réalisation d'une structure à capacité de type Métal-Isolant-Métal avec une résistance d'accès faible.

Avantageusement, une structure à capacité selon l'invention permettra d'obtenir une structure avec une surface d'encombrement restreinte donnant lieu à une forte intégrabilité.

De préférence, une structure selon l'invention sera aisément réalisable et/ou d'un prix de revient faible. Elle pourra avantageusement être intégrée dans une structure comprenant des circuits actifs.

À cet effet, l'invention propose une structure à capacité de type Métal-Isolant-Métal comprenant :
- un substrat,
- une première couche isolante électriquement disposée sur le substrat,
- une électrode inférieure disposée sur la première couche isolante électriquement,
- une couche de métal disposée sur l'électrode inférieure et structurée en ce qu'elle comporte une pluralité de pores, lesdites pores étant isolés électriquement du reste de la couche de métal structurée dans laquelle elles sont réalisées par une couche d'oxyde périphérique électriquement isolante, ladite couche d'oxyde périphérique électriquement isolante constituant une matrice isolante de pores obtenue par gravure anodique ou par anodisation,
- une capacité de type Métal-Isolant-Métal comprenant une première couche conductrice disposée sur la couche de métal structurée et à l'intérieur des pores de ladite couche de métal structurée, une couche diélectrique recouvrant la première couche conductrice, une seconde couche conductrice recouvrant la couche diélectrique, chaque pore concernée comportant la première couche conductrice et la seconde couche conductrice séparées par la couche diélectrique,
- une électrode supérieure disposée sur la capacité de type Métal-Isolant-Métal, et
- une seconde couche isolante électriquement disposée sur l'électrode supérieure.

Selon l'invention, la première couche conductrice située à l'intérieur des pores de la couche de métal structurée est en contact avec l'électrode inférieure, la seconde couche conductrice située à l'intérieur des pores de la couche de métal structurée est en contact avec l'électrode supérieure et l'électrode inférieure comprend une couche de métal et une couche barrière de gravure, ladite couche barrière de gravure étant résistante à la gravure par anodisation et étant située entre la couche de métal de l'électrode inférieure et la matrice isolante de pores.

L'invention propose ainsi une structure originale de capacité de type Métal-Isolant-Métal qui permet grâce à la présence de l'électrode inférieure de court-circuiter la couche conductrice située à l'intérieur des pores et ainsi d'obtenir une structure à capacité de type Métal-Isolant-Métal avec une résistance faible.

La couche barrière de gravure de l'électrode inférieure permet l'ouverture des fonds des pores depuis le haut (c'est-à-dire depuis la surface éloignée du substrat) par gravure anodique.

Une continuité électrique entre la première couche conductrice de la capacité MIM et l'électrode inférieure peut être obtenue lorsque la résistivité électrique de ladite couche barrière de gravure est faible.

On remarque que dans cette structure, les pores de la couche de métal structurée sont isolés électriquement du reste de la couche de métal structurée dans laquelle elles sont réalisées par une couche d'oxyde périphérique. Cette couche d'oxyde qui forme une matrice isolante de pores est créée lors de la réalisation des pores dans une couche de métal pour former la couche de métal structurée. Ainsi, lorsque le métal constitutif de la couche de métal est de l'aluminium, la couche d'oxyde est une couche d'alumine.

Une forme de réalisation avantageuse de l'invention propose une structure à capacité de type Métal-Isolant-Métal comprenant au moins une bande latérale d'isolation placée dans l'électrode inférieure et divisant l'électrode inférieure en deux zones électriquement distinctes, au moins une bande latérale d'isolation placée dans l'électrode supérieure qui divise l'électrode supérieure en deux zones électriquement distinctes et une reprise de contact électrique de l'électrode inférieure étant remontée au niveau de l'électrode supérieure par la couche de métal structurée.

Grâce à la combinaison, d'une part, des pores d'une structure poreuse débouchant sur une électrode inférieure et, d'autre part, la présence des bandes latérales d'isolation, il est réalisé une structure permettant un empilement de capacités montées en parallèle, ce qui autorise d'augmenter sensiblement la valeur de capacité pour une unité de surface donnée.

Comme l'électrode inférieure comprend une couche de métal et une couche barrière de gravure, la couche barrière de gravure vient protéger la couche de métal lorsque les pores sont réalisés dans la couche de métal structurée. La couche barrière de gravure peut être par exemple déposée par PVD (Physical Vapor Déposition) ou ALD (acronyme anglais de « Atomic Layer Déposition » ou en français dépôt par couche atomique) et est alors très fine. Si en outre sa conductivité est faible de par sa nature (TiN, TaN), elle sera toutefois résistive pour des écoulements de charges parallèles à la couche barrière de gravure et/ou sur de grandes distances. Il est donc avantageux de court-circuiter cette couche barrière de gravure pour obtenir de bonnes performance en termes de résistance série (ESR). Ce court-circuit est réalisé par la couche de métal intégrée dans l'électrode inférieure.

Les bandes latérales d'isolation sont préférentiellement constituées d'un matériau isolant choisi par exemple parmi l'oxyde de silicium et le nitrure de silicium dans le but d'isoler deux à deux les électrodes de la capacité de type Métal-Isolant-Métal. Ce matériau est de préférence déposé à basse température par exemple par un procédé de type PECVD.

L'invention propose une forme de réalisation préférée dans laquelle la capacité de type Métal-Isolant-Métal est réalisée dans une couche de métal structurée constituée d'un métal d'une épaisseur supérieure à 0,4 µm permettant d'avoir des cavités telles que des micro-pores ou des nano-pores "profonds" et ainsi d'augmenter la surface totale équivalente (STE) de la capacité.

Dans une structure à capacité de type Métal-Isolant-Métal telle que décrite ici, la matrice isolante de pores est une matrice obtenue par gravure anodique ou par anodisation.

Dans un exemple de réalisation, la couche de métal structurée est en aluminium, la matrice isolante de pores est en alumine.

Dans le but d'augmenter la densité de la capacité de type Métal-Isolant-Métal, la couche diélectrique placée entre les deux couches de métal est avantageusement constituée d'un matériau isolant ayant une constante diélectrique k élevée, supérieure à 4 et préférentiellement supérieure à 10 (k>10).

Grâce à l'utilisation d'une électrode inférieure ainsi que des bandes latérales d'isolation inférieures et supérieures la structure à capacité de type Métal-Isolant-Métal permet l'empilement de plusieurs capacités de type Métal-Isolant-Métal empilées les unes par-dessus les autres. Cet empilement permet d'augmenter la valeur de la capacité de la structure, et par la même, d'augmenter la valeur de la capacité à rapport de surface équivalent constant, permettant ainsi, l'amélioration de l'intégration d'une telle structure selon l'invention. Deux capacités de type Métal-Isolant-Métal de l'empilement sont avantageusement couplées électriquement en parallèle, ce qui permet avantageusement d'additionner les valeurs de capacités pour obtenir des valeurs élevées avec un encombrement constant en surface.

Dans un souci de simplification du procédé technologique, une telle structure à capacités de type Métal-Isolant-Métal selon l'invention, possède une capacité de type Métal-Isolant-Métal de l'empilement connectée électriquement d'une part par son électrode supérieure à l'électrode supérieure d'une autre capacité de type Métal-Isolant-Métal située au-dessus d'elle, et d'autre part par son électrode inférieure à l'électrode inférieure d'une autre capacité de type Métal-Isolant-Métal située au-dessus d'elle. Cet empilement correspond à une caractéristique particulièrement avantageuse de l'invention.

Selon un deuxième aspect, l'invention concerne un produit ou dispositif électronique passif ou actif à semi-conducteur comprenant au moins une structure à capacité de type Métal-Isolant-Métal telle que décrite ci-dessus.

Selon un troisième aspect de l'invention, il est proposé un procédé de fabrication d'une telle structure qui comprend :
a. la préparation d'un substrat,
b. le dépôt d'une première couche isolante électriquement en un matériau isolant sur le substrat,
c. la fabrication d'une électrode inférieure placée sur la première couche isolante électriquement, l'électrode inférieure étant fabriquée en déposant une couche de métal sur la première couche isolante électriquement, ladite couche de métal étant ensuite recouverte d'une couche barrière de gravure résistante à la gravure par anodisation,
d. le dépôt d'un matériau isolant électriquement dans la gravure localisée de l'électrode inférieure,
e. le dépôt d'une couche de métal sur l'électrode inférieure,
f. la structuration de pores dans la couche de métal préférentiellement à l'aide d'un procédé de gravure anodique, lesdites pores étant isolés électriquement du reste de la couche de métal structurée dans laquelle elles sont réalisées par une couche d'oxyde périphérique électriquement isolante, ladite couche d'oxyde périphérique électriquement isolante constituant une matrice isolante de pores,
g. les dépôts successifs d'une première couche conductrice, d'une couche diélectrique et d'une seconde couche conductrice sur la couche de métal structurée et dans les pores de ladite couche structurée,
h. la fabrication d'une électrode supérieure placée sur la seconde couche conductrice,
i. le dépôt d'un matériau isolant électriquement dans la gravure localisée de l'électrode supérieure, et
j. le dépôt d'une seconde couche isolante électriquement en un matériau isolant sur l'électrode supérieure.

Un tel procédé permet de réaliser une structure à capacité de type Métal-Isolant-Métal telle que décrite ci-dessus.

Selon une forme de réalisation, la couche de métal structurée est en aluminium et la matrice isolante de pores est en alumine.

Pour permettre par la suite un empilement de capacités de type Métal-Isolant-Métal, le procédé de fabrication selon l'invention propose avantageusement en outre des étapes :
c1) de fabrication d'une bande latérale d'isolation inférieure par gravure localisée de l'électrode délimitant deux zones électriquement isolées dans l'électrode inférieure après la fabrication de ladite électrode inférieure, et
h1) fabrication d'une bande latérale d'isolation supérieure par gravure localisée de l'électrode délimitant deux zones électriquement isolées dans l'électrode supérieure après la fabrication de ladite électrode supérieure.

Une forme de réalisation avantageuse de l'invention propose un procédé de fabrication dans lequel les étapes c), c1), d) à h) et h1) du procédé de fabrication ci-dessus sont répétées N fois.

Afin de diminuer les discontinuités topographiques on peut prévoir un dépôt d'une couche de planarisation réalisée après au moins une étape h1) du procédé, c'est-à-dire entre deux capacités de type Métal-Isolant-Métal de l'empilement.

D'autres caractéristiques et avantages de l'invention apparaîtront encore à la lecture de la description qui va suivre. Celle-ci est purement illustrative et doit être lue en regard des dessins annexés dans lesquels :
- La Figure n°1 est une vue en coupe d'un exemple d'une structure à capacité de type MIM selon un mode de réalisation de l'invention ;
- Les Figures n°2 à 8 représentent des étapes d'un procédé technologique selon l'invention ;
- La Figure n°9 est une vue en coupe schématique d'une structure à capacité de type MIM selon l'invention ;
- La Figure n°10 est une vue en en coupe schématique d'un empilement de deux capacités de type MIM dans une structure à capacités de type MIM selon l'invention.

A titre liminaire, il est à noter que toutes les figures illustrant des vues en coupe de la structure à capacité ainsi que toutes les figures illustrant des empilements des couches mais également celles représentant des étapes de procédé de fabrication de la structure ne sont pas à l'échelle. De plus, les différentes épaisseurs ne sont pas représentées dans des proportions conformes à la réalité. Dans un souci de simplification, dans la description ainsi que sur les figures, les éléments communs à toutes les structures portent les mêmes références.

L'invention sera plus particulièrement décrite dans un exemple non limitatif d'application à une structure à capacité de type Métal-Isolant-Métal qui sera appelée dans la suite de la description structure à capacité de type MIM. L'exemple de structure à capacité de type MIM décrit ci-après comporte une couche structurée et plus spécialement une couche de métal nano-structurée comportant une pluralité de nano-pores de diamètre d. Les pores de la description qui suit sont des nano-pores mais l'invention peut aussi s'appliquer à une structure comportant des pores d'autres dimensions, par exemple des micro-pores.

La couche de métal peut être un métal comme par exemple de l'aluminium (AI) d'une épaisseur de l'ordre du micromètre (1 µm=10-6 m). Le procédé technologique permettant la création de nano-pores dans la couche de métal sera préférentiellement un procédé utilisant la technique dite de gravure par anodisation. Le procédé de gravure par anodisation sera présenté plus précisément dans la suite de la description.

L'invention porte sur une structure à capacité de type MIM 1 comportant une électrode inférieure 6, une couche nano-structurée 12, une capacité 4 de type MIM déposée sur la couche nano-structurée 12, ladite capacité 4 de type MIM comprenant une première couche conductrice 18 située à l'intérieur des pores de la couche de métal nano-structurée 12 et qui est en contact avec l'électrode inférieure 6, une couche diélectrique 20 et une seconde couche conductrice 24 située à l'intérieur des pores de la couche de métal nano-structurée 12 et qui est en contact avec une électrode supérieure 8.

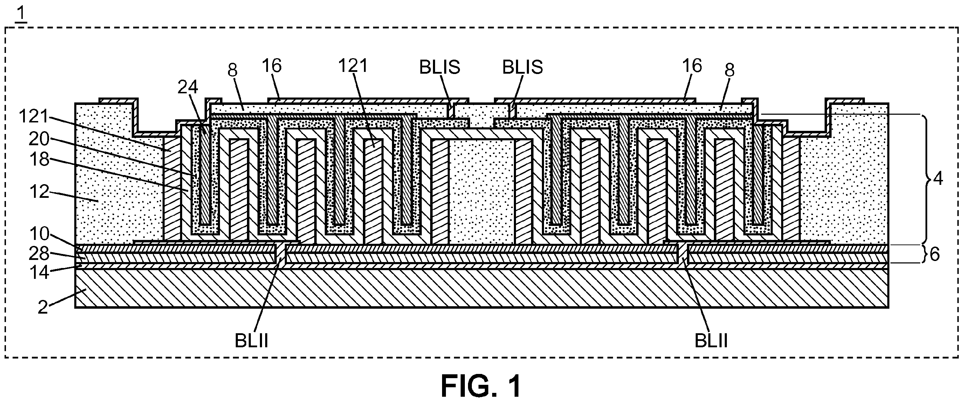

La **Figure n°1** montre un premier exemple d'empilement de couches constituant la structure à capacité de type MIM 1. Elle comprend dans l'ordre croissant d'empilement :
- un substrat 2,
- la première couche isolante 14 électriquement,
- l'électrode inférieure 6 composée d'une couche de métal 28 et d'une couche barrière de gravure 10,
- la couche de métal nano-structurée 12,
- la capacité 4 de type MIM comprenant la première couche conductrice 18, la couche diélectrique 20 et la seconde couche conductrice 24,
- l'électrode supérieure 8,
- une seconde couche isolante 16 électriquement.

La structure à capacité de type MIM 1 représentée sur la **Figure n°1** comporte également une bande latérale d'isolation inférieure nommée BLII et une bande latérale d'isolation supérieure nommée BLIS. Les bandes latérales d'isolation supérieure et inférieure sont dimensionnées pour entourer la structure à capacité MIM 1. La **Figure n°1** étant une vue en coupe de ladite structure à capacité de type MIM 1 il apparaît sur celle-ci deux parties de la bande latérale d'isolation inférieure et deux parties de la bande latérale d'isolation supérieure.

La bande latérale d'isolation inférieure BLII est placée entre la capacité 4 de type MIM et la première couche isolante 14 électriquement. Elle divise l'électrode inférieure 6 en plusieurs zones distinctes électriquement afin d'obtenir une isolation électrique entre la première couche conductrice 18 et la seconde couche conductrice 24 de la capacité 4 de type MIM.

La première couche isolante 14 électriquement placée au-dessus du substrat 2 et en dessous de l'électrode inférieure 6 permet d'isoler électriquement la capacité 4 de type MIM du substrat 2 qui peut être par exemple une plaquette de silicium ou un circuit actif. En effet, dans un souci d'optimisation et d'intégration des composants sur une plaquette de silicium (*en Anglais « wafer* »), il est avantageux d'isoler électriquement la structure à capacité de type MIM 1 afin d'une part de ne pas détériorer ses performances et d'autre part de ne pas influencer par sa présence les autres composants placés aux alentours de celle-ci.

La bande latérale d'isolation supérieure BLIS **(Figure n°1)** divise l'électrode supérieure 8 en plusieurs zones distinctes électriquement afin d'obtenir une isolation électrique entre la première couche conductrice 18 et la seconde couche conductrice 24 de la capacité 4 de type MIM. La bande latérale d'isolation supérieure et la bande latérale d'isolation inférieure permettent ainsi d'obtenir une structure à capacité de type MIM 1 avec un encombrement surfacique restreint et également avec des électrodes d'accès isolées électriquement l'une de l'autre permettant avantageusement un empilement de plusieurs structures à capacité de type MIM 1 les unes sur les autres.

Dans un autre mode de réalisation non représenté aux dessins, il est proposé une structure originale de capacité de type MIM 1 qui permet sans la présence des bandes latérales d'isolation inférieures dans l'électrode inférieure 6 et sans la présence de bandes latérales d'isolation supérieures dans l'électrode supérieure 8 d'obtenir une structure à capacité de type MIM 1 avec une résistance faible. L'électrode inférieure 6 court-circuite la première couche conductrice 18 au fond de chaque pore de la couche de métal nano-structurée 12 permettant ainsi d'obtenir une structure à capacité de type MIM 1 avec une résistance faible.

L'invention propose également un procédé de fabrication de la structure à capacité de type MIM 1 de la Figure 1. Ce procédé comprend :
- la préparation du substrat 2,
- le dépôt d'un matériau isolant pour former la première couche isolante 14 électriquement,
- la fabrication de l'électrode inférieure 6 placée sur la première couche isolante 14 électriquement en déposant tout d'abord la couche de métal 28 et ensuite la couche barrière de gravure 10 au-dessus de ladite couche de métal,
- la fabrication de la bande latérale d'isolation inférieure par gravure localisée de l'électrode inférieure 6 délimitant dans celle-ci des zones électriquement isolées,
- le dépôt d'un matériau isolant électriquement dans la gravure localisée de l'électrode inférieure,
- le dépôt d'une couche de métal sur l'électrode inférieure 6,
- la structuration de nano-pores donne naissance à une couche électriquement isolante à la périphérie des pores appelée matrice isolante de pores 121 dans la couche de métal déposée sur l'électrode inférieure 6 à l'aide préférentiellement d'un procédé de gravure anodique, pour réaliser une couche de métal nano-structurée 12,
- les dépôts successifs de la première couche conductrice 18, d'une couche diélectrique 20 et de la seconde couche conductrice 24 sur la couche de métal nano-structurée 12 et dans les nano-pores de celle-ci,
- la fabrication d'une électrode supérieure 8 placée sur la seconde couche conductrice 24,
- la fabrication de la bande latérale d'isolation supérieure par gravure localisée de l'électrode supérieure 8 délimitant dans celle-ci des zones électriquement isolées,
- le dépôt d'un matériau isolant électriquement dans la gravure localisée de l'électrode supérieure 8 formant ainsi la bande latérale d'isolation supérieure,
- le dépôt d'un matériau isolant sur l'électrode supérieure 8 pour former la seconde couche isolante 16 électriquement.

La couche de métal structurée est ici par exemple en aluminium et la matrice isolante obtenue par anodisation est en alumine.

Plusieurs types de matériaux peuvent être utilisés pour réaliser le substrat 2 en tant que support de la structure à capacité de type MIM 1. Le silicium (Si) qui est majoritairement utilisé dans l'industrie de la micro-électronique pour notamment son coût de revient ainsi que ses caractéristiques semiconductrices permettant la réalisation de composants actifs ou passifs peut être un substrat de choix pour une telle structure. Cependant, il est à noter que des substrats de nature différente peuvent être utilisés, comme par exemple, des substrats en carbure de silicium (SiC) ou des substrats en silice par exemple. Il est à noter que la présente invention est particulièrement adaptée à un substrat sur lequel sont déjà implantés des composants actifs.

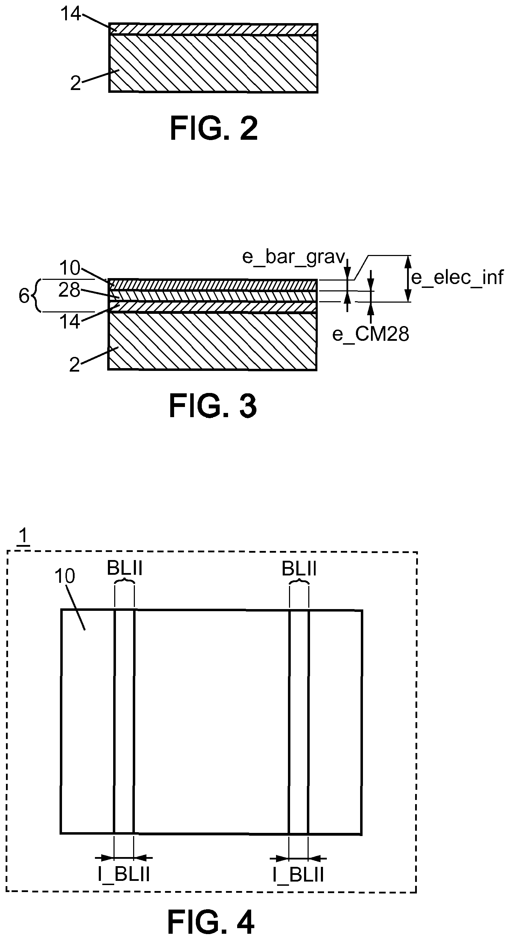

La première couche isolante 14 électriquement **(Figure n°2)** permet grâce à son positionnement de maîtriser les couplages électriques entre la structure à capacité de type MIM 1 et le substrat 2. Le matériau utilisé pour réaliser cette première couche isolante 14 électriquement doit avoir une permittivité électrique k relativement faible afin de réduire les parasites induits par la présence du wafer par exemple. Plusieurs types de matériaux isolants avec une permittivité diélectrique (k de l'ordre de 4 par exemple) peuvent être utilisés, comme par exemple l'oxyde ou le nitrure de silicium (Si3N4). De plus, les matériaux utilisés doivent être compatibles avec les procédés technologiques utilisés pour la fabrication de la structure à capacité de type MIM 1 selon l'invention.

L'électrode inférieure 6 est caractérisée par une surface *surf_elel_inf* et une épaisseur *e_elec_inf* est placée sur la première couche isolante 14 électriquement **(Figure n°3**). Celle-ci est composée de la couche de métal 28 et de la couche barrière de gravure 10 placée au-dessus de la couche de métal 28. La couche de métal 28 peut avoir une épaisseur *e_CM28* comprise par exemple entre 1 µm et 5 µm. De plus, l'électrode inférieure 6 peut comporter d'autres couches non représentées sur la **Figure n°3**. Celles-ci peuvent par exemple êtres intercalées entre la première couche isolante 14 électriquement et la couche de métal 28 pour améliorer l'accroche entres ces deux couches. L'électrode inférieure 6 peut également ne comporter qu'une seule couche comme par exemple la couche barrière de gravure 10.

Les matériaux utilisés pour la création de la couche de métal 28 peuvent être par exemple de l'aluminium (AI), du cuivre (Cu), de l'argent (Ag) combinés ou non avec des métaux barrières comme par exemple du titane (Ti), du nitrure de titane (TiN), du tantale (Ta) ou du nitrure de tantale (TaN). Cette liste n'étant pas exhaustive, d'autres matériaux seul ou en combinaison avec d'autres matériaux, pouvant être déposés selon un procédé de dépôt compatible avec le procédé de fabrication de la structure à capacité de type MIM 1 et ayant de préférence une résistivité électrique équivalente faible, peuvent être utilisés.

La couche barrière de gravure 10 (**Figure n°3**) de l'électrode inférieure 6 présente une épaisseur *e_bar_grav* et a pour rôle de stopper l'attaque de la couche de métal placée sur l'électrode inférieure 6 lors de la gravure anodique pour donner naissance à la couche de métal nano-structurée 12 comme il sera présenté ultérieurement dans la suite de la description. L'épaisseur *e_bar_grav* doit être suffisante pour tolérer la sur-gravure nécessaire au débouchage complet des nano-pores sur ladite couche barrière de gravure 10. L'épaisseur *e_bar_grav* de la couche barrière de gravure 10 est de l'ordre de 1 µm par exemple. Le procédé de fabrication des nano-pores sera décrit plus en détails ultérieurement.

Afin d'assurer une continuité électrique entre la première couche conductrice 18 de la capacité 4 de type MIM et l'électrode inférieure 6, ladite couche barrière de gravure 10 doit avoir une résistivité électrique suffisamment faible. Pour ce faire, ladite couche barrière de gravure 10 peut être par exemple en un métal de type titane (Ti), tantale (Ta), nitrure de titane (TiN) ou en nitrure de tantale (TaN). D'autres matériaux résistant à une anodisation et ayant une résistivité électrique la plus faible possible peuvent être utilisés. De plus, la nature du matériau utilisé pour réaliser cette couche barrière de gravure 10 doit être compatible avec le procédé de gravure par anodisation. Cette compatibilité se traduit par une sélectivité suffisante du procédé de gravure utilisé pour l'ouverture des pores en fin d'anodisation sur ladite couche barrière 10

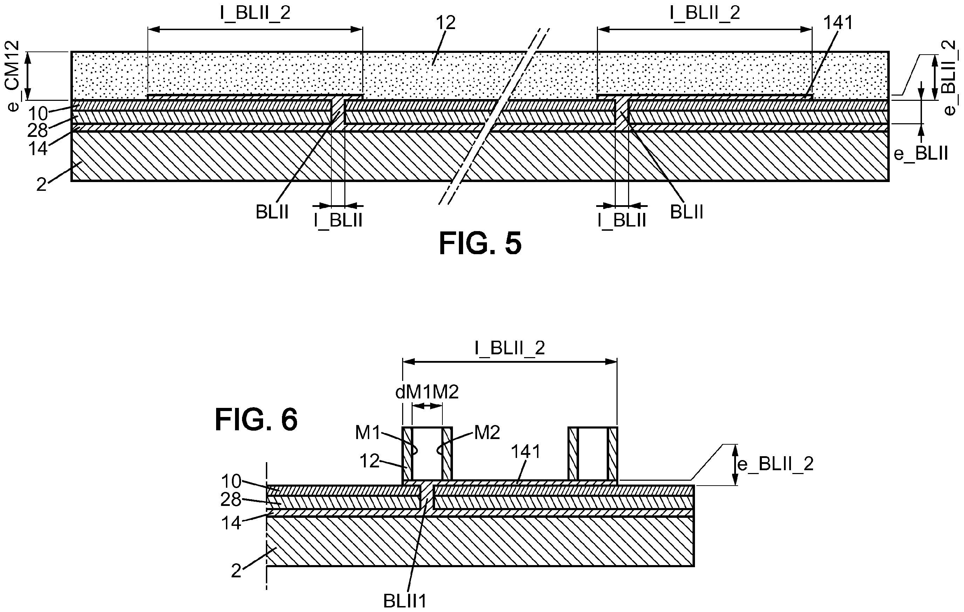

Le procédé de fabrication de la structure à capacité de type MIM 1 selon l'invention permet d'obtenir une structure avec un faible encombrement en surface. Pour ce faire, une bande latérale d'isolation inférieure BLII est réalisée. Pour ce faire, une étape de lithogravure permet de créer des tranchées continues dans la couche barrière de gravure 10 et la couche de métal 28. Ces tranchées délimitent le contour de la première couche conductrice 18 et de la seconde couche conductrice 24 divisant l'électrode inférieure 6 en trois zones distinctes. La largeur l_BLII de cette tranchée **(Figure n°5**) est par exemple de l'ordre de l'épaisseur cumulée de la couche barrière de gravure 10 et de la couche de métal 28 correspondant à la cote e_BLlI. Une couche électriquement isolante est alors déposée par-dessus les structures gravées. L'épaisseur e_BLII_2 de cette couche isolante peut être fine telle que seuls les flancs de l'ouverture l_BLII soient tapissés, ou au contraire suffisamment épaisse pour qu'une operculation de l'ouverture soit réalisée, ce second cas étant représenté sur les **Figures 5** et **6****.** Les bandes latérales d'isolation sont alors réalisées de manière connue de l'homme de l'art qui sait comment obtenir un opercule de largeur l_BLII_2 après gravure **(Figure n°5**).

Les bandes latérales d'isolation inférieures BLII sont constituées d'un matériau électriquement isolant tel que par exemple du nitrure de silicium (Si3N4) déposé en utilisant un mode de dépôt de type PECVD. D'autres matériaux ainsi que d'autres modes de dépôt peuvent être utilisés. La compatibilité avec le procédé de fabrication de la structure à base de capacité de type MIM 1 est cependant nécessaire.

Un opercule 141 situé sur une partie supérieure de la bande latérale d'isolation inférieure BLII est caractérisé par une largeur *l_BLII_2* et une épaisseur *e_BLII_2* permet d'isoler la première couche conductrice 18 de la seconde couche conductrice 24 de la capacité 4 de type MIM (**Figure n°6**) sur une rangée de nano-pores. Afin de s'assurer de l'isolation électrique entre lesdites couches, la longueur de l'opercule 141 est égale à la longueur des bandes latérales d'isolation BLII. De plus, la largeur *l_BLII_2* de l'opercule 141 est supérieure ou égale à la cote l_BLII **(Figure n°6**) et est très supérieure à une distance dM1 M2 correspondant au diamètre d'un pore afin de s'assurer de l'isolation électrique entre la première couche conductrice 18 et la seconde couche conductrice 24.

La **Figure n°5** présente la couche de métal, placée sur la couche barrière de gravure 10 permettant la création de nano-pores. Cette couche d'une épaisseur *e_CM12* est supérieure de préférence à un micromètre et préférentiellement comprise entre 4 µm et 8 µm. La nature du matériau utilisé doit être compatible avec un procédé d'anodisation. Ainsi le métal pour réaliser cette couche peut être de l'aluminium (AI) par exemple. L'anodisation est un procédé électrolytique se déroulant en milieu humide. Le principe repose sur l'application d'une différence de potentiel imposée entre deux électrodes conductrices plongées dans une solution électrolytique qui peut par exemple être acide. L'application d'un potentiel à l'anode, induit une croissance d'alumine à sa surface, si l'électrode est en aluminium, qui lors de sa dissolution dans le bain d'acide provoque l'apparition de nano-pores ou de trous dans la surface du métal.

Avantageusement, grâce au procédé d'anodisation aucune étape de photolithographie n'est utilisée pour créer les pores. Ce procédé permet ainsi d'optimiser le procédé de fabrication d'une telle structure.

Les nano-pores ont avantageusement un diamètre d de l'ordre de 50 nm et sont espacés de 30 nm. De plus, le procédé d'anodisation utilisé dans la présente invention permet l'obtention de nano-pores débouchant sur la couche barrière de gravure 10 de l'électrode inférieure 6. Cette caractéristique est obtenue par une courte sur-gravure humide de la couche anodisée dans une solution, par exemple d'acide sulfurique dilué. En d'autres termes, les nano-pores peuvent être considérés comme des nano-cylindres dont un coté débouche sur la couche barrière de gravure 10. Avantageusement, l'utilisation de l'anodisation pour la fabrication de la capacité 4 permet un rapport de surface déployée STE de l'ordre de 50, préférentiellement 200.

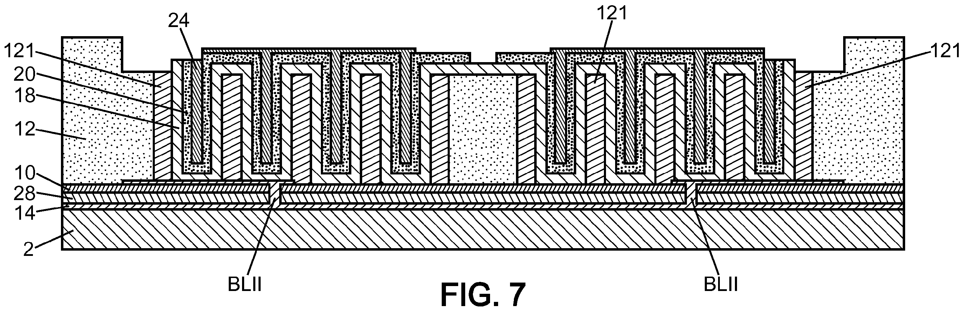

Afin de réaliser la capacité 4 de type MIM la première couche conductrice 18 est ensuite déposée sur la couche de métal nano-structurée 12 et à l'intérieur des nano-pores de ladite couche de métal nano-structurée 12 comme présentée sur la **Figure n°7.** La première couche conductrice 18 située tout au fond des nano-pores vient en contact avec la couche barrière de gravure 10 de l'électrode inférieure 6 permettant d'obtenir une résistance d'accès R_equ faible. Cette première couche conductrice 18 peut être réalisée à l'aide par exemple d'une technique de dépôt de type ALD. Les matériaux utilisés peuvent être par exemple du TiN, du TaN, du NiB, du Ru ou tout autre matériau conducteur utilisant un mode de dépôt permettant d'obtenir un pouvoir couvrant suffisant en accord avec les besoins de l'invention.

En effet, la structure à capacité de type MIM 1 présente de préférence une résistance d'accès nommée R_equ, préférentiellement faible. Cette résistance d'accès R_equ est en outre contrôlée par les caractéristiques internes de l'électrode inférieure 6 et de l'électrode supérieure 8 dont les dimensions et les matériaux sont déterminés de préférence pour obtenir une résistance d'accès R_equ faible. Cette première électrode 6 de la capacité 4 MIM est mise en forme par exemple par un procédé de lithogravure connu de l'art antérieur.

La couche diélectrique 20, permet de créer la capacité entre la première couche conductrice 18 et la seconde couche conductrice 24 formant des électrodes conductrices. Le matériau utilisé pour réaliser cette couche diélectrique 20 doit avoir une permittivité électrique k la plus élevée possible afin de maximiser la valeur de capacité réalisée. Plusieurs types de matériaux dit matériaux « High-k » préférentiellement avec une permittivité électrique (k>6) peuvent être utilisés, comme par exemple, le nitrure de silicium (Si3N4), alumine (oxyde d'aluminium), l'oxyde de hafnium (HfO2), ou tout autre matériau ayant une permittivité électrique k supérieure ou égale aux matériaux cités précédemment. De plus, les matériaux utilisés doivent être compatibles avec les procédés technologiques utilisés pour la fabrication de la structure à capacité de type MIM 1 selon l'invention.

Il est connu de l'homme de l'art que deux paramètres permettent de maîtriser l'effet isolant d'une couche. Ces deux paramètres sont la permittivité électrique k mentionnée précédemment et l'épaisseur de ladite couche. L'épaisseur de la première couche diélectrique est comprise par exemple entre 5 nm et 80 nm (1 nm = 10⁻⁹ m), préférentiellement elle peut être d'une épaisseur de l'ordre de 30 nm.

Les procédés de dépôt permettant d'obtenir la couche diélectrique 20 peuvent utiliser différentes techniques connues de l'homme de l'art. À titre d'exemple, le dépôt par couche atomique (en Anglais « Atomic Layer Depostion » ou *ALD*)*,* ou le dépôt chimique en phase vapeur à basse pression (en Anglais « Low Pressure Chemical Vapor Deposit » ou *LPCVD*) peuvent être préférentiellement utilisées.

La seconde couche conductrice 24 comme présentée sur la **Figure n°7** est ensuite déposée sur la couche diélectrique 20 permettant ainsi de créer la capacité 4 de type MIM. Les caractéristiques de cette seconde couche conductrice 24 ainsi que les méthodes de dépôt peuvent être identiques à celles utilisées pour la réalisation de la première couche conductrice 18.

Les couches constituant la structure MIM comprenant la première couche conductrice 18 et la seconde couche conductrice 24 ainsi que le diélectrique 20 sont mis en forme, comme illustré sur la **Figure n°7,** par exemple par un procédé de lithogravure connu de l'art antérieur.

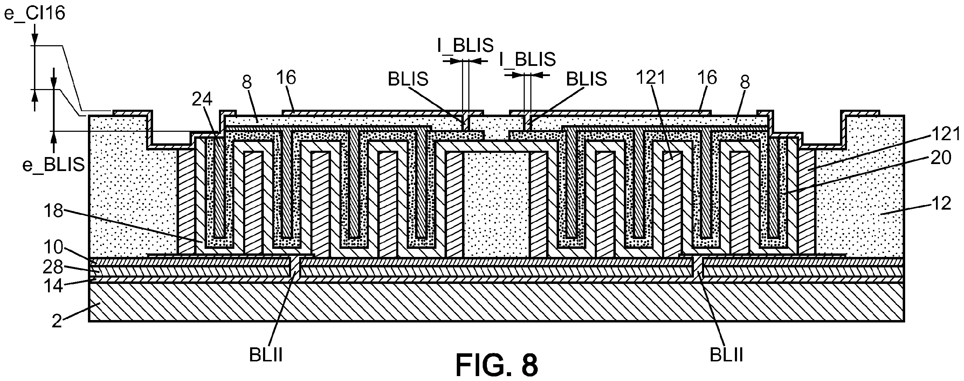

Une couche de métal est ensuite déposée pour constituer l'électrode supérieure 8 comme présentée sur la **Figure n°8.** L'électrode supérieure 8 est caractérisée par une épaisseur dont la valeur est par exemple de l'ordre de 1 µm à 5 µm. La valeur de l'épaisseur de l'électrode supérieure 8 est contrôlée (comme expliqué précédemment dans la description) pour obtenir une valeur de résistance équivalente R_equ de la structure à capacité de type MIM 1 souhaitée. Les matériaux utilisés pour la création de l'électrode supérieure 8 peuvent être par exemple de l'aluminium (AI), du cuivre (Cu), de l'argent (Ag) combinés ou non avec des métaux barrières comme par exemple le nitrure de titane (TiN), ou le nitrure de tantale (TaN). Cette liste n'étant pas exhaustive, d'autres matériaux seul ou en combinaison avec d'autres matériaux pouvant être déposés selon un procédé de dépôt compatible avec le procédé de fabrication de la structure à capacité de type MIM 1 et ayant de préférence une résistivité électrique faible peuvent être utilisés. L'électrode supérieure 8 peut être également réalisée en plusieurs couches (non représentées sur les figures).

La bande latérale d'isolation supérieure BLIS est caractérisée par une épaisseur *e_BLIS* et une largeur *l_BLIS* comme présenté sur la **Figure n°8.** La bande latérale d'isolation supérieure BLIS est constituée d'un matériau électriquement isolant tel que par exemple du nitrure de silicium (Si3N4) déposée par exemple en utilisant un mode de dépôt de type PECVD. D'autres matériaux ainsi que d'autres modes de dépôt peuvent être utilisés. La compatibilité avec le procédé de fabrication de la structure à base de capacité de type MIM 1 est cependant nécessaire.

Les caractéristiques dimensionnelles de la bande latérale d'isolation supérieure BLIS (**Figure n°8**) sont équivalentes à celles de la bande latérale d'isolation inférieure BLII. De plus, la largeur *l_BLIS* de la bande latérale d'isolation supérieure BLIS est très supérieure au diamètre d d'un nano-pore afin d'éviter un court-circuit entre la première couche conductrice 18 et la seconde couche conductrice 24 de la capacité 4 de type MIM.

Le procédé de fabrication de la bande latérale d'isolation supérieure BLIS est de préférence identique à celui de la bande latérale d'isolation inférieure BLII.

La seconde couche isolante 16 électriquement est ensuite déposée sur l'électrode supérieure 8. Le matériau a préférentiellement une permittivité électrique k faible afin d'éliminer tout court-circuit ou bruit électrique parasite induit. Plusieurs types de matériaux peuvent être utilisés comme par exemple le nitrure de silicium (Si3N4), l'oxyde de silicium (SiO2), ou tout autre matériau ayant une permittivité électrique inférieure ou égale aux matériaux cités précédemment et de plus compatibles avec les procédés technologiques décrits aux paragraphes précédents.

La seconde couche isolante 16 électriquement comme présentée sur la **Figure n°8** est caractérisée par une épaisseur nommée *e_CI16* dont la valeur est de l'ordre par exemple de 100 nm. Des procédés de dépôt permettant d'obtenir une telle seconde couche isolante 16 électriquement étant connus de l'homme de l'art et déjà décrits précédemment lors de la réalisation de l'électrode inférieure 6 ne seront pas repris ici.

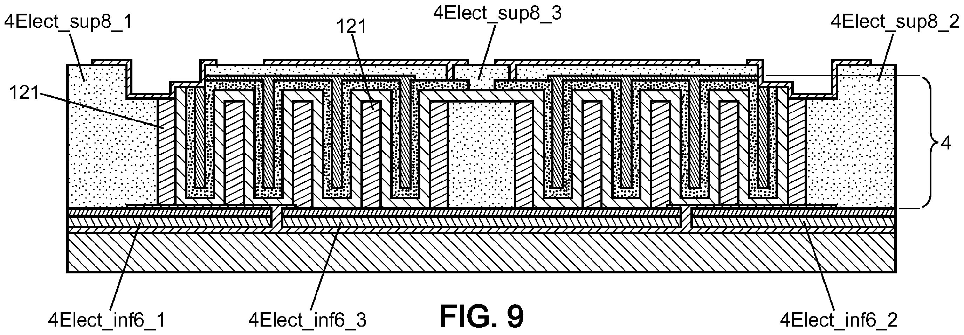

La bande latérale d'isolation inférieure BLII et la bande latérale d'isolation supérieure BLIS permettent de diviser respectivement l'électrode inférieure et l'électrode supérieure et ainsi elles permettent la création de zones distinctes électriquement isolées. Dans un souci de clarté de la description les zones distinctes de chaque électrode sont dans la suite nommées pour l'électrode inférieure 6 respectivement 4Elect_inf6_1, 4Elect_inf6_2, 4Elect_inf6_3 et pour l'électrode supérieure 8 respectivement 4Elect sup8_1,4Elect sup8 2, 4Elect_sup8_3. La **Figure n°9** présente une vue de ces différentes zones.

La présence de la couche de métal nano-structurée 12 permet le couplage d'une part entre la zone 4Elect inf6_1 de l'électrode inférieure 6 et la zone 4Elect_sup8_1 de l'électrode supérieure 8 qui sera dans la suite de la description nommée électrode latérale gauche, et d'autre part entre la zone nommée 4Elect_inf6_2 de l'électrode inférieure 6 et la zone 4Elect_sup8_2 de l'électrode supérieure 8 qui sera dans la suite de la description nommée également électrode latérale droite. De plus, la couche de métal nano-structurée 12 permet le couplage entre la zone 4Elect_inf6_3 de l'électrode inférieure 6 et la zone 4Elect_sup8_3 de l'électrode supérieure 8 et sera nommée électrode centrale. Ainsi, il est formée les bornes de la capacité 4 de type MIM de part et d'autre de la structure à capacité de type MIM 1. Dans un mode de réalisation, l'électrode latérale gauche et l'électrode latérale droite sont couplées entre elles.

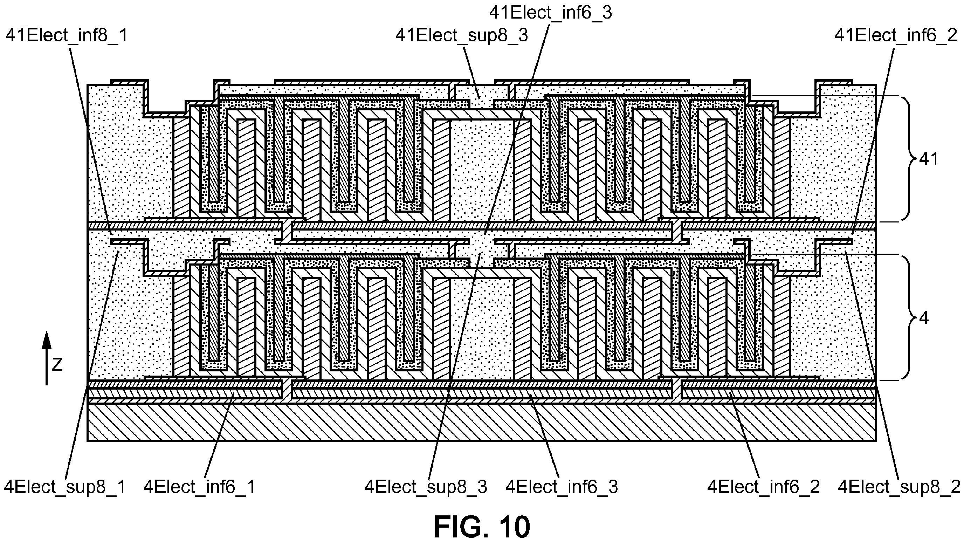

Afin d'obtenir une structure à capacité de type MIM 1 avec une forte intégrabilité verticale en Z (**Figure n°10**) un mode de réalisation de l'invention prévoit de dupliquer N étages dans une structure à capacités de type MIM. Afin de simplifier la description, un exemple de structure à capacités de type MIM composée de deux (N=2) étages nommés E_1 et E_2 est représenté sur le graphique de la **Figure n°10.** Il est à noter que le procédé de fabrication des N étages est identique au procédé de fabrication de la structure à capacité de type MIM 1 et par conséquent il ne sera pas décrit en détails dans la suite de la description.

Le procédé permettant de réaliser une structure à capacités de type MIM selon l'invention comprend :
- la préparation du substrat 2,
- le dépôt d'une première couche isolante 14 électriquement en un matériau isolant,
- la fabrication du premier étage E_1 avec la capacité 4 de type MIM,
- la fabrication du second étage E_2 avec une capacité 41 de type MIM.

Les zones de chaque électrode de chaque empilement sont maintenant nommées (**Figure n°10**) pour l'empilement E_1 comportant la capacité 4 de type MIM 4Elect_inf6_1, 4Elect_inf6_2, 4Elect_inf6_3 et 4Elect_sup8_1, 4Elect_sup8_2, 4Elect_sup8_3. En ce qui concerne l'empilement E_2 comportant la capacité 41 de type MIM celles-ci sont nommées 41Elect_inf6_1, 41 Elect_inf6_2, 41Elect_inf6_3 et 41Elect_sup8_1, 41 Elect_sup8_2, 41Elect_sup8_2.

Avantageusement, grâce à la présence des bandes latérales d'isolation de chaque capacité de l'empilement une électrode latérale gauche constituée de la zone 41Elect sup8_1 de la capacité 41 est reliée à la zone 41Elect inf6_1 elle-même reliée à la zone 4Elect_sup8_1 de la capacité 4 de type MIM qui est elle-même reliée à la zone 4Elect_inf6_1. De même, une autre électrode latérale droite est constituée de la zone 41Elect_sup8_2 de la capacité 41 est reliée à la zone 41Elect_inf6_2 elle-même reliée à la zone 4Elect_sup8_2 de la capacité 4 de type MIM qui est elle-même reliée à la zone 4Elect_inf6_2. Une électrode centrale est constituée de la zone 41Elect_sup8_3 de la capacité 41 est reliée à la zone 41Elect_inf6_3 elle-même reliée à la zone 4Elect_sup8_3 de la capacité 4 de type MIM qui est elle-même reliée à la zone 4Elect_inf6_3.

Dans une mode de réalisation l'électrode latérale gauche et l'électrode latérale droite sont couplées entre elles. Ce couplage entre les différentes zones de chaque capacité 4, 41 permet ainsi d'obtenir un couplage de type parallèle entre lesdites capacités 4, 41. Ce couplage de type parallèle entre les capacités 4, 41 de l'empilement permet d'ajouter les valeurs de chaque capacité 4, 41 de la structure à capacités de type MIM et ainsi d'obtenir une structure à capacités de type MIM à haute densité d'intégration.

De plus, pour une structure à capacités de type MIM comprenant N empilements la valeur de la capacité totale de la structure à capacités de type MIM sera égale à la somme des valeurs de chaque capacité 4, 41, ..., 4N de l'empilement.

Par ailleurs cet empilement permet de diviser la résistance série du composant puisque la résistance globale correspond à la résistance individuelle de chaque élément, divisée par le nombre d'éléments parallélisés.

Lors de la conception d'une telle structure, il peut apparaitre des problématiques de planarité entre les différentes couches constituant ladite structure à capacités de type MIM. En effet, la présence de nombreuse couches superposées peut donner naissance à des discontinuités topographiques de la structure à capacités de type MIM.

Afin de diminuer cette discontinuité topographique, il est envisageable d'ajouter entre chaque empilement une couche dite planarisante (non représentée sur les Figures) qui permet de réduire toutes discontinuités topographiques dues à la présence d'une pluralité de couches sur le substrat 2. Cette couche planarisante peut être déposée dès que le nombre d'étages est supérieur à 1.

La présente invention permet ainsi la réalisation d'une structure à capacité de type MIM 1 avec une résistance d'accès R_equ faible grâce au contact de la première couche conductrice 18 sur la couche barrière de gravure 10, ainsi qu'à la mise en parallèle des résistances des différents étages, avec un faible encombrement en surface. De plus, la présente invention permet grâce à l'utilisation de bandes latérales d'isolation inférieure et supérieure d'obtenir une structure à capacités de type MIM avec un encombrement en Z restreint avec une forte valeur de capacité par unité de surface.

En outre, le procédé de fabrication proposé ici est compatible avec la plupart des procédés de réalisation de composants actifs ce qui permet une intégration d'une structure selon la présente invention dans des circuits complexes intégrant des composants passifs et actifs et en particulier dans les niveaux d'interconnexion. De la sorte, le rapport capacitance / encombrement est optimisé et les coûts de revient de l'intégration d'éléments capacitifs de forte valeur peuvent être sensiblement réduits.

La description ci-dessus a été donnée à titre illustratif seulement et n'est pas limitative de la portée de l'invention. Toute variante de réalisation techniquement envisageable peut être préférée aux modes de réalisation décrits. De même, les étapes du procédé technologique décrites dans l'invention sont données à titre illustratif et ne sont pas limitées aux exemples donnés ici. Enfin, il est bien entendu que les différents perfectionnements décrits peuvent être utilisés séparément ou en combinaison, selon les qualités et performances recherchées pour une structure à capacité de type MIM selon l'invention.

## Revendications

1. Structure à capacité de type Métal-Isolant-Métal (1) comprenant :
- un substrat (2),
- une première couche isolante (14) électriquement disposée sur le substrat (2),
- une électrode inférieure (6) disposée sur la première couche isolante (14) électriquement,
- une couche de métal (12) disposée sur l'électrode inférieure (6) et structurée en ce qu'elle comporte une pluralité de pores, lesdites pores étant isolés électriquement du reste de la couche de métal structurée (12) dans laquelle elles sont réalisées par une couche d'oxyde périphérique électriquement isolante (121), ladite couche d'oxyde périphérique électriquement isolante constituant une matrice isolante de pores (121) obtenue par gravure anodique ou par anodisation,
- une capacité (4 ; 41) de type Métal-Isolant-Métal comprenant une première couche conductrice (18) disposée sur la couche de métal structurée (12) et à l'intérieur de pores de ladite couche de métal structurée (12), une couche diélectrique (20) recouvrant la première couche conductrice (18), une seconde couche conductrice (24) recouvrant la couche diélectrique (20), chaque pore concernée comportant la première couche conductrice (18) et la seconde couche conductrice (24) séparées par la couche diélectrique (20),
- une électrode supérieure (8) disposée sur la capacité (4) de type Métal-Isolant-Métal,
- une seconde couche isolante (16) électriquement disposée sur l'électrode supérieure (8),
dans laquelle:
- la première couche conductrice (18) située à l'intérieur des pores de la couche de métal structurée (12) est en contact avec l'électrode inférieure (6),
- la seconde couche conductrice (24) située à l'intérieur des pores de la couche de métal structurée (12) est en contact avec l'électrode supérieure (8), et - l'électrode inférieure (6) comprend une couche de métal (28) et une couche barrière de gravure (10), ladite couche barrière de gravure (10) étant résistante à la gravure par anodisation et étant située entre la couche de métal (28) de l'électrode inférieure (6) et la matrice isolante de pores (121).

2. Structure à capacité de type Métal-Isolant-Métal (1) selon la revendication 1 comprenant
- au moins une bande latérale d'isolation placée dans l'électrode inférieure (6) et divisant l'électrode inférieure (6) en deux zones électriquement distinctes, et
- au moins une bande latérale d'isolation placée dans l'électrode supérieure (8) et divisant l'électrode supérieure (8) en deux zones distinctes électriquement,
une reprise de contact électrique de l'électrode inférieure (6) étant remontée au niveau de l'électrode supérieure (8) par la couche de métal structurée (12).

3. Structure à capacité de type Métal-Isolant-Métal (1) selon l'une des revendications 1 ou 2, **caractérisé en ce qu'**il y a une continuité électrique entre la première couche conductrice (18) et l'électrode inférieure (6) grâce à la résistivité électrique faible de ladite couche barrière de gravure (10).

4. Structure à capacité de type Métal-Isolant-Métal (1) selon l'une des revendications 2 ou 3, **caractérisée en ce que** les bandes latérales d'isolation sont constituées d'un matériau isolant choisi dans l'ensemble contenant l'oxyde de silicium et le nitrure de silicium.

5. Structure à capacité de type Métal-Isolant-Métal (1) selon l'une des revendications 1 à 4, **caractérisée en ce que** la couche de métal structurée (12) est micro ou nano-structurée et est constituée d'un métal d'une épaisseur supérieure à 0,4 µm.

6. Structure à capacité de type Métal-Isolant-Métal (1) selon l'une quelconque des revendications 1 à 5, **caractérisée en ce que** la couche de métal structurée (12) est en aluminium et la matrice isolante de pores (121) est en alumine.

7. Structure à capacité de type Métal-Isolant-Métal (1) selon l'une des revendications 1 à 6, **caractérisée en ce que** la couche diélectrique (20) est constituée d'un matériau isolant ayant une constante diélectrique k élevée, supérieure à 4 (k>4) et préférentiellement supérieure à 10.

8. Structure à capacité de type Métal-Isolant-Métal (1) selon l'une des revendications 1 à 7, **caractérisée en ce qu'**elle comporte plusieurs capacités (4) de type Métal-Isolant-Métal empilées les unes par-dessus les autres.

9. Structure à capacité de type Métal-Isolant-Métal (1) selon la revendication 8, **caractérisée en ce que** deux capacités de type Métal-Isolant-Métal de l'empilement sont couplées électriquement en parallèle.

10. Structure à capacité de type Métal-Isolant-Métal (1) selon l'une des revendications 8 ou 9, **caractérisée en ce qu'**une capacité de type Métal-Isolant-Métal de l'empilement est connectée électriquement d'une part par son électrode supérieure (8) à l'électrode supérieure (8) d'une autre capacité de type Métal-Isolant-Métal et d'autre part par son électrode inférieure (6) à l'électrode inférieure (6) d'une autre capacité de type Métal-Isolant-Métal située au-dessus d'elle.

11. Dispositif électronique passif ou actif à semi-conducteur comprenant au moins une structure à capacité de type Métal-Isolant-Métal (1) selon l'une des revendications de 1 à 10.

12. Procédé de fabrication d'une structure à capacité de type Métal-Isolant-Métal (1), comprenant :
a. la préparation d'un substrat (2),
b. le dépôt d'une première couche isolante (14) électriquement en un matériau isolant sur le substrat (2),
c. la fabrication d'une électrode inférieure (6) placée sur la première couche isolante (14) électriquement, l'électrode inférieure (6) étant fabriquée en déposant une couche de métal (28) sur la première couche isolante (14) électriquement, ladite couche de métal (28) étant ensuite recouverte d'une couche barrière de gravure (10) résistante à la gravure par anodisation,
d. le dépôt d'un matériau isolant électriquement dans la gravure localisée de l'électrode inférieure (6),
e. le dépôt d'une couche de métal sur l'électrode inférieure (6),
f. la structuration de pores dans la couche de métal à l'aide d'un procédé de gravure anodique, lesdites pores étant isolés électriquement du reste de la couche de métal structurée dans laquelle elles sont réalisées par une couche d'oxyde périphérique électriquement isolante, ladite couche d'oxyde périphérique électriquement isolante constituant une matrice isolante de pores (121),
g. les dépôts successifs d'une première couche conductrice (18), d'une couche diélectrique (20) et d'une seconde couche conductrice (24) sur la couche de métal structurée (12) et dans les pores de ladite couche structurée (12),
h. la fabrication d'une électrode supérieure (8) placée sur la seconde couche conductrice (24),
i. le dépôt d'un matériau isolant électriquement dans la gravure localisée de l'électrode supérieure (8),
j. le dépôt d'une seconde couche isolante (16) électriquement en un matériau isolant sur l'électrode supérieure (8).

13. Procédé de fabrication selon la revendication 12, **caractérisée en ce que** la couche de métal structurée (12) est en aluminium et la matrice isolante de pores (121) formée par gravure anodique est en alumine.

14. Procédé de fabrication d'une structure à capacité de type Métal-Isolant-Métal selon l'une des revendications 12 et 13, **caractérisé en ce qu'**il y a une continuité électrique entre la première couche conductrice (18) et l'électrode inférieure (6) grâce à la résistivité électrique faible de ladite couche barrière de gravure (10).

15. Procédé de fabrication d'une structure à capacité de type Métal-Isolant-Métal selon l'une des revendications 12 à 14, **caractérisé en ce qu'**il comporte en outre des étapes :
c1. de fabrication d'une bande latérale d'isolation inférieure par gravure localisée de l'électrode délimitant deux zones électriquement isolées dans l'électrode inférieure après la fabrication de ladite électrode inférieure, et
h1. de fabrication d'une bande latérale d'isolation supérieure par gravure localisée de l'électrode délimitant deux zones électriquement isolées dans l'électrode supérieure après la fabrication de ladite électrode supérieure.

16. Procédé de fabrication d'une structure à capacité de type Métal-Isolant-Métal selon la revendication 15, **caractérisé en ce que** les étapes c), c1), d) à h) et h1) du procédé de fabrication sont répétées N fois.

17. Procédé de fabrication d'une structure à capacités de type Métal-Isolant-Métal selon la revendication 16, **caractérisé en ce qu'**il prévoit le dépôt d'une couche de planarisation après au moins une étape h1) du procédé.

## Patentansprüche

1. Struktur mit Kondensator vom Typ Metall-Isoliermaterial-Metall (1), umfassend:
- ein Substrat (2),
- eine erste elektrisch isolierende Schicht (14), die auf dem Substrat (2) angeordnet ist,
- eine untere Elektrode (6), die auf der ersten elektrisch isolierenden Schicht (14) angeordnet ist,
- eine Metallschicht (12), die auf der unteren Elektrode (6) angeordnet und so strukturiert ist, dass sie mehrere Poren beinhaltet, wobei die Poren von dem Rest der strukturierten Metallschicht (12) elektrisch isoliert sind, in der sie durch eine elektrisch isolierende Umfangsoxidschicht (121) umgesetzt sind, wobei die elektrisch isolierende Umfangsoxidschicht eine isolierende Matrix von Poren (121) darstellt, die durch anodisches Ätzen oder durch Anodisierung erhalten wird,
- einen Kondensator (4; 41) vom Typ Metall-Isoliermaterial-Metall, umfassend eine erste leitende Schicht (18), die auf der strukturierten Metallschicht (12) und innerhalb der Poren der strukturierten Metallschicht (12) angeordnet ist, eine dielektrische Schicht (20), welche die erste leitende Schicht (18) bedeckt, eine zweite leitende Schicht (24), welche die dielektrische Schicht (20) bedeckt, wobei jede betreffende Pore die erste leitende Schicht (18) und die zweite leitende Schicht (24) beinhaltet, die durch die dielektrische Schicht (20) getrennt sind,
- eine obere Elektrode (8), die auf dem Kondensator (4) vom Typ Metall-Isoliermaterial-Metall angeordnet ist,
- eine zweite elektrisch isolierende Schicht (16), die auf der oberen Elektrode (8) angeordnet ist,
wobei:
- die erste leitende Schicht (18), die sich innerhalb der Poren der strukturierten Metallschicht (12) befindet, in Kontakt mit der unteren Elektrode (6) steht,
- die zweite leitende Schicht (24), die sich innerhalb der Poren der strukturierten Metallschicht (12) befindet, in Kontakt mit der oberen Elektrode (8) steht, und
- die untere Elektrode (6) eine Metallschicht (28) und eine Barriereätzschicht (10) umfasst, wobei die Barriereätzschicht (10) widerstandsfähig gegen das anodische Ätzen ist und sich zwischen der Metallschicht (28) der unteren Elektrode (6) und der isolierenden Matrix von Poren (121) befindet.

2. Struktur mit Kondensator vom Typ Metall-Isoliermaterial-Metall (1) nach Anspruch 1, umfassend:
- mindestens einen Isolierseitenstreifen, der in der unteren Elektrode (6) platziert ist und die untere Elektrode (6) in zwei elektrisch unterschiedliche Bereiche unterteilt, und
- mindestens einen Isolierseitenstreifen, der in der oberen Elektrode (8) platziert ist und die obere Elektrode (8) in zwei elektrisch unterschiedliche Bereiche unterteilt,
wobei eine Wiederaufnahme von elektrischem Kontakt der unteren Elektrode (6) auf Höhe der oberen Elektrode (8) durch die strukturierte Metallschicht (12) angebracht ist.

3. Struktur mit Kondensator vom Typ Metall-Isoliermaterial-Metall (1) nach einem der Ansprüche 1 oder 2, **dadurch gekennzeichnet, dass** es dank der schwachen elektrischen Widerstandsfähigkeit der Barriereätzschicht (10) eine elektrische Kontinuität zwischen der ersten leitenden Schicht (18) und der unteren Elektrode (6) gibt.

4. Struktur mit Kondensator vom Typ Metall-Isoliermaterial-Metall (1) nach einem der Ansprüche 2 oder 3, **dadurch gekennzeichnet, dass** die Isolierseitenstreifen aus einem isolierenden Material bestehen, das aus der Gruppe ausgewählt ist, die Siliziumoxid und Siliziumnitrid enthält.

5. Struktur mit Kondensator vom Typ Metall-Isoliermaterial-Metall (1) nach einem der Ansprüche 1 bis 4, **dadurch gekennzeichnet, dass** die strukturierte Metallschicht (12) mikro- oder nanostrukturiert ist und aus einem Metall mit einer Dicke größer als 0,4 µm besteht.

6. Struktur mit Kondensator vom Typ Metall-Isoliermaterial-Metall (1) nach einem der Ansprüche 1 bis 5, **dadurch gekennzeichnet, dass** die strukturierte Metallschicht (12) aus Aluminium besteht und die isolierende Matrix von Poren (121) aus Aluminium besteht.

7. Struktur mit Kondensator vom Typ Metall-Isoliermaterial-Metall (1) nach einem der Ansprüche 1 bis 6, **dadurch gekennzeichnet, dass** die dielektrische Schicht (20) aus einem isolierenden Material besteht, das eine erhöhte dielektrische Konstante k größer als 4 (k>4) und vorzugsweise größer als 10 aufweist.

8. Struktur mit Kondensator vom Typ Metall-Isoliermaterial-Metall (1) nach einem der Ansprüche 1 bis 7, **dadurch gekennzeichnet, dass** sie mehrere Kondensatoren (4) vom Typ Metall-Isoliermaterial-Metall beinhaltet, die aufeinandergestapelt sind.

9. Struktur mit Kondensator vom Typ Metall-Isoliermaterial-Metall (1) nach Anspruch 8, **dadurch gekennzeichnet, dass** zwei Kondensatoren vom Typ Metall-Isoliermaterial-Metall des Stapels elektrisch parallel gekoppelt sind.

10. Struktur mit Kondensator vom Typ Metall-Isoliermaterial-Metall (1) nach einem der Ansprüche 8 oder 9, **dadurch gekennzeichnet, dass** ein Kondensator vom Typ Metall-Isoliermaterial-Metall des Stapels elektrisch einerseits durch seine obere Elektrode (8) mit der oberen Elektrode (8) eines anderen Kondensators vom Typ Metall-Isoliermaterial-Metall und andererseits durch seine untere Elektrode (6) mit der unteren Elektrode (6) eines anderen Kondensators vom Typ Metall-Isoliermaterial-Metall, der sich darüber befindet, verbunden ist.

11. Passive oder aktive elektronische Halbleitervorrichtung, umfassend mindestens eine Struktur mit Kondensator vom Typ Metall-Isoliermaterial-Metall (1) nach einem der Ansprüche 1 bis 10.

12. Verfahren zur Herstellung einer Struktur mit Kondensator vom Typ Metall-Isoliermaterial-Metall (1), umfassend:
a. Vorbereiten eines Substrats (2),
b. Abscheiden einer ersten elektrisch isolierenden Schicht (14) aus einem isolierenden Material auf dem Substrat (2),
c. Herstellen einer unteren Elektrode (6), die auf der ersten elektrisch isolierenden Schicht (14) platziert wird, wobei die untere Elektrode (6) hergestellt wird, indem eine Metallschicht (28) auf der ersten elektrisch isolierenden Schicht (14) abgeschieden wird, wobei die Metallschicht (28) anschließend von einer Barriereätzschicht (10) bedeckt wird, die widerstandsfähig gegen anodisches Ätzen ist,
d. Abscheiden eines elektrisch isolierenden Materials in der lokalisierten Ätzung der unteren Elektrode (6),
e. Abscheiden einer Metallschicht auf der unteren Elektrode (6),
f. Strukturieren von Poren in der Metallschicht mit Hilfe eines Verfahrens des anodischen Ätzens, wobei die Poren von dem Rest der strukturierten Metallschicht, in der sie durch eine elektrisch isolierende Umfangsoxidschicht umgesetzt sind, elektrisch isoliert sind, wobei die elektrisch isolierende Umfangsoxidschicht eine isolierende Matrix von Poren (121) darstellt,
g. aufeinanderfolgendes Abscheiden einer ersten leitenden Schicht (18), einer dielektrischen Schicht (20) und einer zweiten leitenden Schicht (24) auf der strukturierten Metallschicht (12) und in den Poren der strukturierten Schicht (12),
h. Herstellen einer oberen Elektrode (8), die auf der zweiten leitenden Schicht (24) platziert wird,
i. Abscheiden eines elektrisch isolierenden Materials in der lokalisierten Ätzung der oberen Elektrode (8),
j. Abscheiden einer zweiten elektrisch isolierenden Schicht (16) in einem isolierenden Material auf der oberen Elektrode (8).

13. Verfahren zur Herstellung nach Anspruch 12, **dadurch gekennzeichnet, dass** die strukturierte Metallschicht (12) aus Aluminium besteht und die isolierende Matrix von Poren (121), die durch anodisches Ätzen gebildet wird, aus Aluminium besteht.

14. Verfahren zur Herstellung einer Struktur mit Kondensator vom Typ Metall-Isoliermaterial-Metall nach einem der Ansprüche 12 und 13, **dadurch gekennzeichnet, dass** es dank der schwachen elektrischen Widerstandsfähigkeit der Barriereätzschicht (10) eine elektrische Kontinuität zwischen der ersten leitenden Schicht (18) und der unteren Elektrode (6) gibt.

15. Verfahren zur Herstellung einer Struktur mit Kondensator vom Typ Metall-Isoliermaterial-Metall nach einem der Ansprüche 12 bis 14, **dadurch gekennzeichnet, dass** es ferner die Schritte umfasst des:
c1. Herstellens eines unteren Isolierseitenstreifens durch lokalisiertes Ätzen der Elektrode, die zwei elektrisch isolierte Bereiche begrenzt, in der unteren Elektrode nach der Herstellung der unteren Elektrode, und
h1. Herstellens eines oberen Isolierseitenstreifens durch lokalisiertes Ätzen der Elektrode, die zwei elektrisch isolierte Bereiche begrenzt, in der oberen Elektrode nach der Herstellung der oberen Elektrode.

16. Verfahren zur Herstellung einer Struktur mit Kondensator vom Typ Metall-Isoliermaterial-Metall nach Anspruch 15, **dadurch gekennzeichnet, dass** die Schritte c), c1), d) bis h) und h1) des Verfahrens zur Herstellung N-mal wiederholt werden.

17. Verfahren zur Herstellung einer Struktur mit Kondensator vom Typ Metall-Isoliermaterial-Metall nach Anspruch 16, **dadurch gekennzeichnet, dass** es die Abscheidung einer Planarisierungsschicht nach mindestens einem Schritt h1) des Verfahrens vorsieht.

## Claims

1. A Metal-Insulator-Metal type capacitor structure (1) comprising:
- a substrate (2),
- a first electrically insulating layer (14) disposed on the substrate (2),
- a lower electrode (6) disposed on the first electrically insulating layer (14),
- a metal layer (12) disposed on the lower electrode (6) and structured in that it includes a plurality of pores, said pores being electrically insulated from the rest of the structured metal layer (12) in which they are made by an electrically insulating peripheral oxide layer (121), said electrically insulating peripheral oxide layer constituting an insulating matrix of pores (121) obtained by anodic etching or by anodization,
- a Metal-Insulator-Metal type capacitor (4; 41) comprising a first conductive layer (18) disposed on the structured metal layer (12) and inside the pores of said structured metal layer (12), a dielectric layer (20) covering the first conductive layer (18), a second conductive layer (24) covering the dielectric layer (20), each concerned pore including the first conductive layer (18) and the second conductive layer (24) separated by the dielectric layer (20),
- an upper electrode (8) disposed on the Metal-Insulator-Metal type capacitor (4),
- a second insulating layer (16) electrically disposed on the upper electrode (8),
in which:
- the first conductive layer (18) located inside the pores of the structured metal layer (12) is in contact with the lower electrode (6),
- the second conductive layer (24) located inside the pores of the structured metal layer (12) is in contact with the upper electrode (8), and
- the lower electrode (6) comprises a metal layer (28) and an etching barrier layer (10), said etching barrier layer (10) being resistant to etching by anodization and being located between the metal layer (28) of the lower electrode (6) and the insulating pore matrix (121).

2. The Metal-Insulator-Metal type capacitor structure (1) according to claim 1 comprising
- at least one insulating side strip placed in the lower electrode (6) and dividing the lower electrode (6) into two electrically separate areas, and
- at least one insulating side strip placed in the upper electrode (8) and dividing the upper electrode (8) into two electrically separate areas,
an electrical contact recovery of the lower electrode (6) being raised to the level of the upper electrode (8) by the structured metal layer (12).

3. The Metal-Insulator-Metal type capacitor structure (1) according to one of claims 1 or 2, **characterized in that** there is electrical continuity between the first conductive layer (18) and the lower electrode (6) thanks to the low electrical resistivity of said etching barrier layer (10).

4. The Metal-Insulator-Metal type capacitor structure (1) according to one of claims 2 or 3, **characterized in that** the insulating side strips consist of an insulating material selected from the set containing the silicon oxide and silicon nitride.

5. The Metal-Insulator-Metal type capacitor structure (1) according to one of claims 1 to 4, **characterized in that** the structured metal layer (12) is micro or nano-structured and consists of a metal with a thickness greater than 0.4 µm.

6. The Metal-Insulator-Metal type capacitor structure (1) according to any one of claims 1 to 5, **characterized in that** the structured metal layer (12) is made of aluminum and the insulating matrix of pores (121) is made of alumina.

7. The Metal-Insulator-Metal type capacitor structure (1) according to one of claims 1 to 6, **characterized in that** the dielectric layer (20) consists of an insulating material having a high dielectric constant k, greater than 4 (k>4) and preferably greater than 10.

8. The Metal-Insulator-Metal type capacitor structure (1) according to one of claims 1 to 7, **characterized in that** it includes several Metal-Insulator-Metal type capacitors (4) stacked on top of one another.

9. The Metal-Insulator-Metal type capacitor structure (1) according to claim 8, **characterized in that** two Metal-Insulator-Metal type capacitors of the stack are electrically coupled in parallel.

10. The Metal-Insulator-Metal type capacitor structure (1) according to one of claims 8 or 9, **characterized in that** a Metal-Insulator-Metal type capacitor of the stack is electrically connected on the one hand by its upper electrode (8) to the upper electrode (8) of another Metal-Insulator-Metal type capacitor and on the other hand by its lower electrode (6) to the lower electrode (6) of another Metal-Insulator-Metal type capacitor located above it.

11. A passive or active semiconductor electronic device comprising at least one Metal-Insulator-Metal type capacitor structure (1) according to one of claims 1 to 10.

12. A method for manufacturing a Metal-Insulator-Metal type capacitor structure (1), comprising:
a. preparing a substrate (2),
b. depositing a first electrically insulating layer (14) made of an insulating material on the substrate (2),
c. manufacturing a lower electrode (6) placed on the first electrically insulating layer (14), the lower electrode (6) being manufactured by depositing a metal layer (28) on the first electrically insulating layer (14), said metal layer (28) then being covered with an etching barrier layer (10) resistant to etching by anodization,
d. depositing an electrically insulating material in the localized etching of the lower electrode (6),
e. depositing a metal layer on the lower electrode (6),
f. structuring pores in the metal layer using an anodic etching method, said pores being electrically insulated from the rest of the structured metal layer in which they are produced by an electrically insulating peripheral oxide layer, said electrically insulating peripheral oxide layer constituting an insulating matrix of pores (121),
g. successively depositing a first conductive layer (18), a dielectric layer (20) and a second conductive layer (24) on the structured metal layer (12) and in the pores of said structured layer (12),
h. manufacturing an upper electrode (8) placed on the second conductive layer (24),
i. depositing an electrically insulating material in the localized etching of the upper electrode (8),
j. depositing a second electrically insulating layer (16) made of an insulating material on the upper electrode (8).

13. The manufacturing method according to claim 12, **characterized in that** the structured metal layer (12) is made of aluminum and the insulating pore matrix (121) formed by anodic etching is made of alumina.

14. The method for manufacturing a Metal-Insulator-Metal type capacitor structure according to one of claims 12 and 13, **characterized in that** there is electrical continuity between the first conductive layer (18) and the lower electrode (6) thanks to the low electrical resistivity of said etching barrier layer (10).

15. The method for manufacturing a Metal-Insulator-Metal type capacitor structure according to one of claims 12 to 14, **characterized in that** it further includes steps:
c1. of manufacturing a lower insulating side strip by localized etching of the electrode delimiting two electrically insulated areas in the lower electrode after the manufacturing of said lower electrode, and
h1. of manufacturing an upper insulating side strip by localized etching of the electrode delimiting two electrically insulated areas in the upper electrode after the manufacturing of said upper electrode.

16. The method for manufacturing a Metal-Insulator-Metal type capacitor structure according to claim 15, **characterized in that** steps c), c1), d) to h) and h1) of the manufacturing method are repeated N times.

17. The method for manufacturing a Metal-Insulator-Metal type capacitor structure according to claim 16, **characterized in that** it provides for the deposition of a planarization layer after at least one step h1) of the method.
